# FASCICULE DE BREVET EUROPEEN

(11) **EP 3 464 686 B1**
(45) Date de publication et mention de la délivrance du brevet: **22.04.2020**
(21) Numéro de dépôt: 17745412.1
(22) Date de dépôt: 30.06.2017
(51) Int. Cl.: C30B 7/08, C30B 29/22, C30B 7/14

(54) **DISPOSITIF DE CROISSANCE D'UN MONOCRISTAL PLAN À PARTIR D'UN GERME CRISTALLIN DANS UNE SOLUTION DE CRISTALLISATION ET PROCÉDÉ DE FABRICATION DE CE MONOCRISTAL**
VORRICHTUNG ZUR ZÜCHTUNG EINES FLACHEN EINKRISTALLS AUS EINEM IMPFKRISTALL IN EINER KRISTALLISATIONSLÖSUNG UND VERFAHREN ZUR HERSTELLUNG DIESES EINKRISTALLS
DEVICE FOR GROWING A FLAT SINGLE CRYSTAL FROM A SEED CRYSTAL IN A CRYSTALLIZATION SOLUTION AND PROCESS FOR MANUFACTURING THIS SINGLE CRYSTAL

(30) Priorité: 04.07.2016 FR 1656379
(43) Date de publication de la demande: 10.04.2019
(73) Titulaire: Commissariat à l'Énergie Atomique et aux Énergies Alternatives, 75015 Paris (FR)
(72) Inventeur: VISSIE, Pascal, 37250 MONTBAZON (FR); GROSIL, Max, 37260 MONTS (FR); PINTAULT, Bruno, 37260 MONTS (FR)
(74) Mandataire: Brevalex
(86) Numéro de dépôt international: PCT/FR2017/051774
(87) Numéro de publication internationale: WO 2018/007729

(56) Documents cités:
- WO-A1-99/09236
- CN-A- 103 541 007
- SU-A1- 488 611
- ZAITSEVA N P ET AL: "Rapid growth of large-scale (40-55 cm) KH"2PO"4 crystals", JOURNAL OF CRYSTAL GROWTH, ELSEVIER, AMSTERDAM, NL, vol. 180, no. 2, 1 septembre 1997 (1997-09-01), pages 255-262, XP004111809, ISSN: 0022-0248, DOI: 10.1016/S0022-0248(97)00223-6

## Description

### DOMAINE TECHNIQUE

La présente invention a trait à la production de monocristaux en forme de plaques par croissance en solution à partir d'un germe cristallin.

L'invention concerne en particulier un dispositif de croissance d'un monocristal plan ayant un système de protection du germe cristallin.

### ÉTAT DE LA TECHNIQUE ANTÉRIEURE

Un monocristal peut être obtenu par croissance cristalline à partir d'un germe placé dans une solution sursaturée d'un sel de même nature que le cristal.

Cette méthode de croissance peut par exemple être utilisée pour réaliser des monocristaux de dihydrogénophosphate de potassium (KDP) ou de dihydrogénophosphate de potassium deutéré (DKDP) de grandes dimensions, ces monocristaux étant nécessaires pour la réalisation de certains éléments optiques utilisés dans les lasers de puissance pour la fusion par confinement inertiel, notamment des interrupteurs optiques (sous forme de cellules de Pockels) ou des convertisseurs de fréquences (doubleur (SHG) ou tripleur (THG) de fréquence).

A l'issue de la croissance, on obtient un monocristal dans lequel sont découpées des plaques dont l'orientation par rapport au système cristallin dépend de l'utilisation que l'on souhaite faire du cristal (en cellules de Pockels, en doubleur (SHG) ou en tripleur de fréquence (THG)).

L'évolution d'un cristal plongé dans une solution dépend du niveau de saturation de la solution. Si la solution est sursaturée, c'est-à-dire si la quantité de sel dissous est plus importante que la quantité à l'équilibre, le cristal croit par consommation du sel en excès dans la solution. La vitesse de croissance du cristal dépend du niveau de sursaturation de la solution, qui peut être contrôlé par abaissement de la température de la solution ou évaporation du solvant. Elle dépend aussi du renouvellement de la couche limite de solution autour du cristal. *A contrario,* un cristal plongé dans une solution sous-saturée se dissout jusqu'à ce que la quantité de sel dissous dans la solution atteigne la quantité à l'équilibre. Le cristal peut ainsi disparaître complétement.

Dans les dispositifs de croissance en solution connus, la croissance du cristal est libre et non contrainte. Le cristal se développe dans la solution sursaturée sur le plateau inférieur d'une plate-forme de croissance, qui est en rotation simple ou alternée, pour former un prisme tétragonal surmonté d'une pyramide tétragonale.

Pour la production en croissance rapide en solution sursaturée de très grands cristaux, de KDP ou de DKDP par exemple, le germe cristallin (c'est-à-dire le cristal initial) est un cube d'environ 1 cm de côté qui est plongé dans une solution sursaturée de plusieurs centaines de litres.

Une perturbation extérieure, telle que des vibrations, peut entrainer des nucléations multiples et l'apparition de nombreux parasites.

Pour rendre la solution sursaturée plus stable face aux perturbations extérieures, on effectue préalablement à la croissance un traitement de sous-saturation pendant plusieurs jours, en élevant la température de la solution au-dessus de sa température d'équilibre. Si le germe est au contact de la solution à ce moment-là, il se dissout. Si l'on attend que la température de la solution soit proche de la température d'équilibre pour introduire le germe, on perd le bénéfice du traitement de sous-saturation, car la perturbation créée par l'introduction du germe a toutes les chances de produire des parasites.

Pour résoudre ce problème, il est connu du document [1] un dispositif de croissance qui est équipé d'un système de protection du germe.

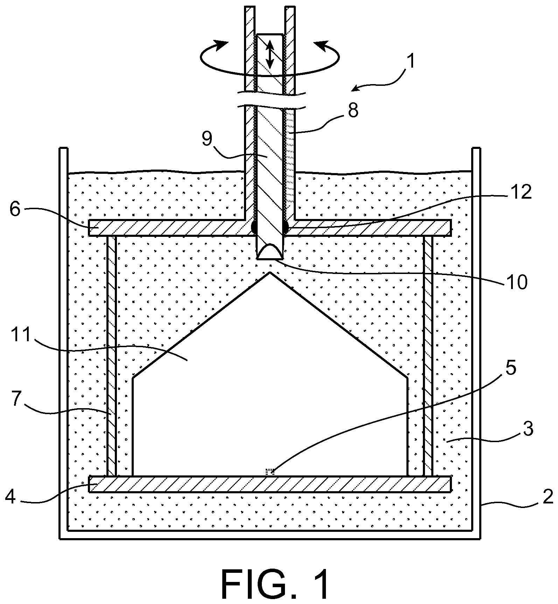

Dans la figure 1, le dispositif de croissance 1 décrit dans le document [1] de l'art antérieur comporte un ensemble (également appelé « plate-forme de croissance ») qui est formé d'un plateau inférieur 4, ayant une face de support destinée à supporter le germe 5, un plateau supérieur 6 et deux piliers 7 (également appelés entretoises), reliant les deux plateaux entre eux et les maintenant à une distance fixe l'un de l'autre. La plate-forme est suspendue dans la cuve 2 par un arbre de rotation 8 creux, qui sert d'axe de rotation à la plate-forme. Le germe est collé au centre du plateau inférieur 4 de la plate-forme. Une tige 9 est montée coulissante dans l'arbre de rotation 8 et possède, à sa base, un évidement formant une cavité 10 destinée à accueillir le germe 5.

Le dispositif de croissance 1 est introduit dans une cuve de croissance 2 et cette cuve est ensuite remplie avec une solution de croissance 3. Avant le remplissage de la cuve par la solution de croissance 3, la tige 9 est abaissée au contact du plateau inférieur 4. Le germe 5 est enfermé dans la cavité 10 créée à la base de la tige 9. Il est donc protégé de la solution 3 pendant les étapes de remplissage de la cuve 2 par la solution 3 et pendant les étapes de surchauffe et de filtration de la solution 3 (traitement de sous-saturation), préalables à la croissance du germe. On obtient donc une solution de croissance 3 qui est sous-saturée.

Pour démarrer la croissance du germe, la tige 9 est relevée pour mettre le germe 5 au contact de la solution de croissance 3 sous-saturée. Le germe se dissous légèrement pendant que la température de la solution est abaissée jusqu'à atteindre le niveau de sursaturation souhaité de la solution. Puis, le volume du germe croît dans la solution 3 sursaturée pour atteindre les dimensions et la forme du cristal 11 par consommation du composé dissous dans le solvant de la solution 3.

La base de la tige 9 est suffisamment haute pour ne pas gêner la croissance du cristal 11. Un joint torique 12, placé dans une gorge du plateau supérieur 6, assure l'étanchéité au niveau du jeu entre l'axe de l'arbre 8 et la tige 9.

Par ailleurs, afin d'améliorer le rendement de production en termes de nombre de plaques découpées par unité de volume de cristal, il a été proposé de réaliser la croissance à partir d'un germe correctement orienté et de contraindre la croissance du cristal dans certaines directions (document **[2]**).

L'orientation cristallographique du germe est choisie en fonction de l'élément optique (cellule de Pockels, SHG ou THG) que l'on souhaite découper dans le cristal. Dans le cas des cellules de Pockels, la direction cristallographique [001] du germe de KDP est perpendiculaire au plateau inférieur sur lequel il est collé. Dans le cas d'une croissance pour la découpe de plaques pour SHG, la direction [001] forme un angle θ d'environ 41° avec la normale au plan du plateau inférieur 4 sur lequel il est collé et la direction [110] est dans le plan du plateau inférieur. Enfin, pour la réalisation de plaques pour THG, la direction [001] forme un angle θ d'environ 59° avec la normale au plan du plateau inférieur 4 et la direction [100] est dans le plan du plateau inférieur.

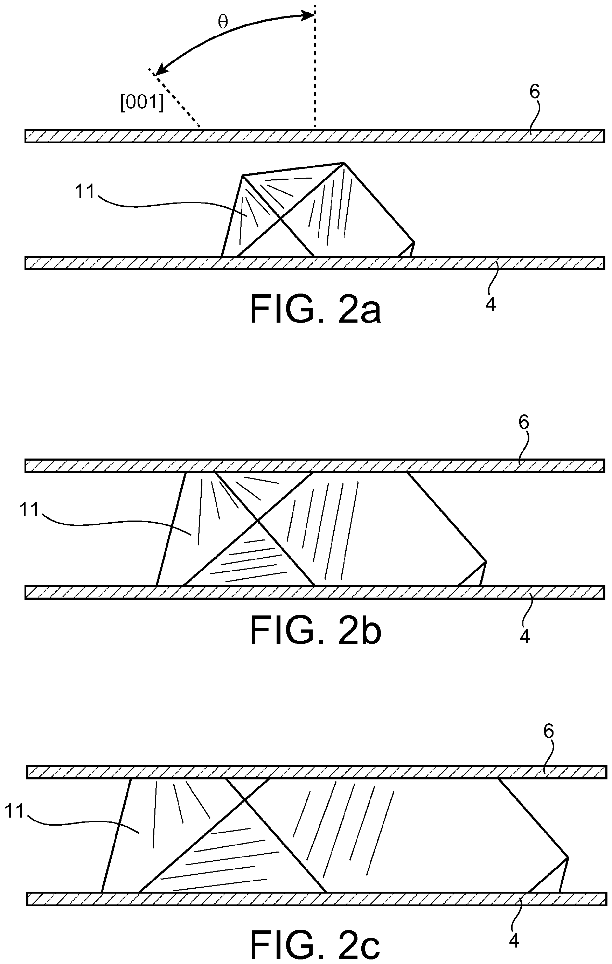

C'est le plateau supérieur 6 de la plate-forme qui contraint le cristal dans une croissance sur les côtés comme illustré sur les figures 2a à 2c. Le cristal 11 en croissance se développe entre le plateau inférieur 4 et le plateau supérieur 6 de la plate-forme en rotation alternée (figure 2a). Au contact du plateau supérieur 6, le cristal ne peut croitre dans la direction verticale et il poursuit sa croissance latéralement (figures 2b et 2c).

Dans ce procédé de croissance contraint entre le plateau inférieur et le plateau supérieur, le plateau supérieur doit être plan. Or, l'utilisation d'une tige dans laquelle est pratiquée une cavité pour la protection du germe ne répond pas à cette exigence.

### EXPOSÉ DE L'INVENTION

L'invention a pour objectif principal de résoudre les inconvénients des dispositifs de l'art antérieur en fournissant un dispositif de croissance qui soit équipé d'un système de protection de germe et qui puisse être utilisé dans un procédé de croissance contraint.

A cet égard, l'invention propose un dispositif de croissance d'un monocristal plan à partir d'un germe cristallin dans une solution de cristallisation, ledit dispositif de croissance comprenant :
- un élément de support ayant une face de support destinée à supporter le germe cristallin ; et
- un élément de blocage comprenant une face de blocage, la face de blocage étant disposée à une distance prédéfinie de la face de support de manière à bloquer la croissance du monocristal dans une direction sensiblement perpendiculaire à la face de support ;
le dispositif de croissance étant caractérisé en ce qu'il comprend en outre un organe de protection du germe cristallin, configuré pour protéger ledit germe de la solution de cristallisation pendant une phase de traitement de la solution de cristallisation et pour libérer une zone de croissance disposée entre la face de support et la face de blocage lors d'une mise en rotation de l'élément de support ;
l'élément de blocage comportant en outre un organe de maintien coopérant avec l'organe de protection, ledit organe de maintien étant déplaçable entre une première position dans laquelle il maintient l'organe de protection contre la face de support pendant la phase de traitement et une deuxième position dans laquelle l'organe de maintien est désolidarisé de l'organe de protection et participe à la formation de la face de blocage.

Certains aspects préférés mais non limitatifs du dispositif selon l'invention sont les suivants :
- la face de support et la face de blocage sont des faces planes ;
- l'organe de protection est un corps creux définissant une cavité ouverte destinée à recouvrir le germe pendant la phase de traitement; il peut par exemple avoir la forme d'une demi-sphère ou d'une cloche ;
- l'élément de blocage comporte un corps plan dont une surface définit la face de blocage, ce corps ayant un trou traversant qui délimite une ouverture dans la face de blocage et dans lequel l'organe de maintien coulisse entre les première et deuxième positions ;
- l'organe de maintien est une tige dont une extrémité est munie d'une surface plane ayant une forme correspondant à celle de l'ouverture dans la face de blocage ; la surface plane de l'extrémité est destinée à venir, dans la première position de l'organe de maintien, en appui contre l'organe de protection et, dans la deuxième position de l'organe de maintien, boucher l'ouverture pour former la face de blocage ;
- l'organe de protection comporte, sur une surface extérieure, un méplat formant une surface d'appui plane sur laquelle s'appuie l'organe de maintien dans la première position ;
- la face de support et la face de blocage sont parallèles l'une par rapport à l'autre ; cela permet d'obtenir un monocristal en forme de plaque ; l'élément de support et le corps de l'élément bloquant sont de préférence des plateaux (plaques planes).

L'invention concerne également une installation pour la croissance en solution d'un monocristal, comprenant une cuve destinée à contenir une solution de cristallisation, un dispositif de croissance tel que décrit ci-dessus, disposé dans la cuve, et des moyens de mise en rotation du dispositif dans la cuve. Les moyens de mise en rotation sont bien connus de l'homme du métier. La rotation, généralement alternée dans un sens puis dans l'autre, est le plus souvent assurée par un moteur électrique dont on programme les phase d'accélération de vitesse et de décélération avant la rotation, avec les mêmes paramètres dans un sens et dans le sens contraire.

L'invention concerne aussi un procédé de fabrication d'un monocristal par croissance en solution à partir d'un germe cristallin par mise en œuvre de l'installation telle que décrite ci-dessus, le procédé comprenant :
- la fixation du germe cristallin sur la face de support de l'élément de support, le germe cristallin étant orienté suivant l'orientation du monocristal désiré ;
- la mise en place de l'organe de protection autour du germe et son maintien sur la face de support de l'élément de support par pression sur l'organe de protection par l'intermédiaire de l'organe de maintien, qui est placé dans sa première position ;
- la mise en contact de l'organe de protection avec la solution de cristallisation par immersion du dispositif dans la solution de cristallisation ;
- le traitement de la solution de cristallisation pour obtenir une solution sous-saturée ;
- la mise en contact du germe avec la solution de cristallisation sous-saturée par déplacement de l'organe de maintien de sa première position vers sa deuxième position et la mise en rotation du dispositif autour d'un axe essentiellement perpendiculaire à la face de support (cet axe passant de préférence par l'organe de maintien), le déplacement de l'élément de maintien et la mise en rotation libérant l'organe de protection ;
- la modification de la température de la solution de croissance pour obtenir une solution sursaturée ;
- la croissance du monocristal entre la face de support et la face de blocage à partir de la solution sursaturée, cette croissance étant poursuivie jusqu'à l'obtention d'une croissance latérale désirée ;
- le détachement du monocristal de la face de support et de la face de blocage.

L'étape de traitement de la solution de cristallisation pour obtenir une solution sous-saturée est bien connue de l'homme du métier et n'est pas décrite ici. Elle comporte généralement une étape de surchauffe, et éventuellement une étape de filtration, de la solution. Elle permet d'obtenir une solution de sous-saturation qui, après la modification de la température de la solution, sera dans des conditions de sursaturation propices à la croissance du monocristal.

Généralement, la modification de la température de la solution de croissance pour obtenir une solution sursaturée sera un abaissement de la température si la solubilité, dans le solvant de la solution de cristallisation, du matériau formant le cristal augmente avec la température.

De préférence, l'immersion du dispositif dans la solution de cristallisation est obtenue par introduction de la solution dans la cuve contenant le dispositif ; en d'autres termes, le dispositif est introduit dans la cuve avant la solution.

Le procédé selon l'invention est applicable à toute méthode de croissance d'un cristal en solution. Avantageusement, dans le procédé de fabrication selon l'invention, le monocristal est un monocristal de dihydrogénophosphate de potassium (KDP) ou de dihydrogénophosphate de potassium deutéré (DKDP).

Le dispositif de croissance selon l'invention permet de remédier au problème de protection du germe dans un système de croissance entre plateaux plans pour produire des cristaux en forme de plaques.

La conception particulière du dispositif de croissance selon l'invention permet notamment :
- la protection du germe en évitant le contact entre le germe et la solution de croissance durant l'étape de remplissage de la cuve de croissance et l'étape de traitement de la solution de cristallisation (pendant laquelle on prépare la solution de sorte à obtenir une solution sous-saturée ; cette étape de traitement peut comprendre, de manière connue, une opération de surchauffe et éventuellement une opération de filtration de la solution) ;
- la libération du germe, préalablement au lancement de la phase de croissance, sans créer de perturbations excessives de la solution de cristallisation sous-saturée ; et
- l'obtention d'une surface plane au niveau de la face de blocage lorsque l'organe de maintien est dans sa deuxième position.

### BRÈVE DESCRIPTION DES DESSINS

L'invention sera mieux comprise et d'autres avantages et particularités apparaitront à la lecture de la description qui va suivre, donnée à titre d'exemple non limitatif, accompagnée des dessins annexés parmi lesquels :
- la figure 1, déjà décrite, illustre un dispositif de croissance connu utilisé pour réaliser la croissance rapide d'un monocristal et disposant d'un système connu de protection du germe ;
- les figures 2a à 2c, déjà décrites, illustrent les étapes de croissance contrainte d'un monocristal en forme de plaque à l'aide d'un dispositif de croissance contrainte connu ;
- les figures 3a à 3c illustrent des étapes du procédé de croissance selon l'invention à l'aide du dispositif de croissance selon l'invention.

### EXPOSÉ DÉTAILLÉ DE MODES DE RÉALISATION PARTICULIERS

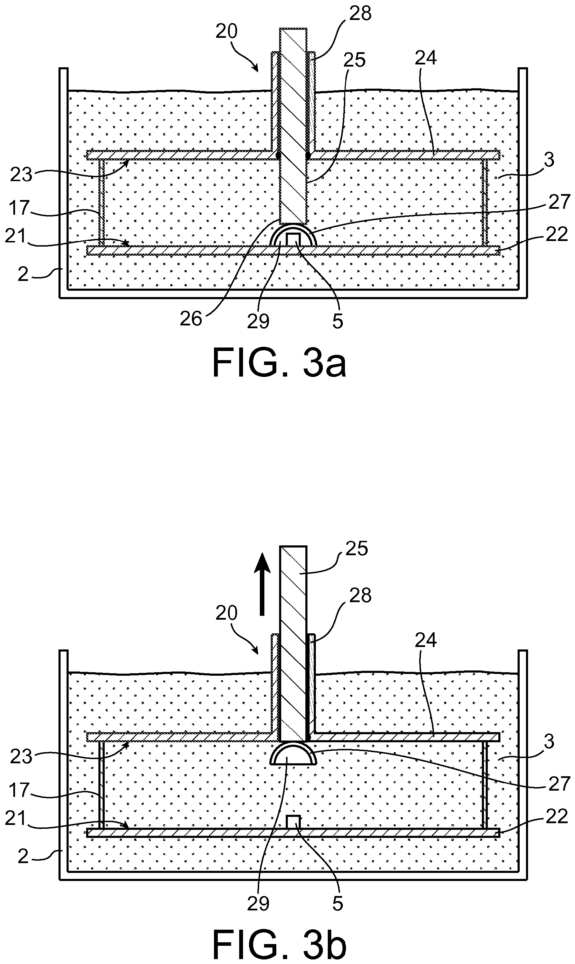

Un exemple de configuration possible du dispositif de croissance 20 selon l'invention est illustré dans les figures 3a à 3c.

Ici, l'élément de support 22 est sous la forme d'une plaque et forme le plateau inférieur d'une plate-forme de croissance.

L'élément de blocage 24 est lui aussi sous la forme d'une plaque, qui forme le plateau supérieur de la plate-forme ; l'élément de support 22 et l'élément de blocage 24 ont leurs faces qui sont parallèles.

L'élément de blocage 24 est une plaque comportant un trou traversant permettant le passage de l'organe de maintien, qui est ici une tige 25 dont une extrémité 26 à surface plane est destinée à venir faire appui contre l'organe de protection 27. Ici, l'élément de blocage 24 sous forme de plaque est en outre équipée d'un arbre de rotation creux 28 qui sert de guide à la tige et dans lequel la tige coulisse de sa première position vers sa deuxième position et vice-versa.

L'élément de support 22 et l'élément de blocage 24 sont reliés l'un à l'autre par au moins deux moyens de liaison, par exemple des entretoises 17, qui permettent de solidariser ces deux éléments et de maintenir une distance prédéfinie entre la face de support 21 et la face de blocage 23. L'élément de support 22, l'élément de blocage 24 et les moyens de liaison forment une plate-forme de croissance. Ces éléments étant reliés entre eux, on peut noter que la rotation de l'élément de support 22 provoque également la rotation de l'élément de blocage et, en somme, la rotation de la plate-forme dans sa totalité.

Le germe 5 pour la croissance en solution est collé sur la face de support de l'élément de support 22.

L'organe de protection 27 du germe est une enveloppe qui a ici la forme d'une cloche ; il est positionné autour du germe avant que la solution de croissance 3 ne soit introduite dans la cuve 2. Ainsi, l'organe de protection 27 protège le germe 5 de la solution 3 en créant une poche d'air 29 autour du germe. L'organe de protection 27 du germe est maintenu plaqué contre l'élément de support 22 par la tige 25.

Le germe 5 est libéré et mis au contact de la solution de croissance 3 en soulevant la tige 25. La tige 25, dont l'extrémité basse 26 est plane, forme une surface plane avec l'élément de blocage lorsqu'elle est soulevée jusqu'au niveau de l'élément de blocage 24; la réunion de l'élément de blocage et de l'extrémité plane de la tige forme alors la face de blocage 23. La géométrie du dispositif de croissance 20 selon l'invention est donc compatible avec la production de monocristaux en forme de plaques obtenus par le blocage de la croissance par un plan situé au-dessus du germe forçant la croissance latérale du cristal.

Lorsque la tige 25 est soulevée, l'organe de protection 27 du germe 5 se soulève lui aussi sous l'effet de la poussée d'Archimède et est entrainé vers le haut lors de la remontée de la tige 25 et libère le germe 5 (figure 3b).

Afin de faciliter l'appui de l'organe de protection 27 du germe 5 sur l'extrémité basse 26 de la tige 25, l'organe de protection (ici, sous la forme d'une cloche) peut avoir un méplat sur l'apex de sa surface extérieure.

Sous l'effet de la rotation, simple ou alternée, appliquée à l'élément de support autour de son axe de rotation (qui passe par l'arbre 28), l'organe de protection du germe bascule. Compte tenu de la forme extérieure de l'organe de protection du germe (cloche), la rotation simple ou alternée de l'élément de support favorise son retournement et son expulsion pour tomber au fond de la cuve de croissance.

Cet effet de bascule peut être amplifié en décentrant légèrement l'organe de protection 25 par rapport à l'axe de rotation de l'élément de support (qui est le plus souvent situé au centre de l'élément de support) au moment de sa mise en place.

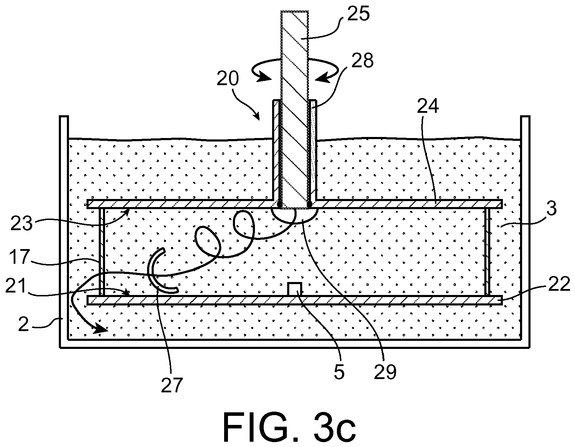

Une fois éjecté, la poussée d'Archimède devient plus faible que les forces de gravité s'exerçant sur l'organe de protection 27 du germe et ce dernier coule pour se placer en fond de la cuve de croissance 2. Il ne représente alors plus une gêne pour la croissance du cristal entre l'élément de support 22 et l'élément de blocage 24 (figure 3c).

Bien évidemment, les différents éléments constituant le dispositif objet de l'invention sont réalisés dans des matériaux compatibles avec la solution de cristallisation, ainsi qu'avec les conditions de croissance du monocristal.

### REFERENCES CITEES

**[1]** US 5,904,772
**[2]** FR 2 764 909 B1

## Revendications

1. Dispositif de croissance (20) d'un monocristal plan à partir d'un germe cristallin (5) dans une solution de cristallisation (3), ledit dispositif de croissance comprenant :
- un élément de support (22) ayant une face de support (21) destinée à supporter le germe cristallin ; et
- un élément de blocage (24) comprenant une face de blocage (23), la face de blocage étant disposée à une distance prédéfinie de la face de support de manière à bloquer la croissance du monocristal dans une direction sensiblement perpendiculaire à la face de support ;
le dispositif de croissance étant **caractérisé en ce qu'**il comprend en outre un organe de protection (27) du germe cristallin, configuré pour protéger ledit germe de la solution de cristallisation (3) pendant une phase de traitement de la solution de cristallisation et pour libérer une zone de croissance disposée entre la face de support (21) et la face de blocage (23) lors d'une mise en rotation de l'élément de support (22) ;
l'élément de blocage (24) comportant en outre un organe de maintien (25) coopérant avec l'organe de protection (27), ledit organe de maintien étant déplaçable entre une première position dans laquelle il maintient l'organe de protection (27) contre la face de support (21) pendant la phase de traitement et une deuxième position dans laquelle l'organe de maintien (25) est désolidarisé de l'organe de protection (27) et participe à la formation de la face de blocage (23).

2. Dispositif selon la revendication 1, dans lequel l'organe de protection (27) est un corps creux définissant une cavité ouverte destinée à recouvrir le germe pendant la phase de traitement.

3. Dispositif selon la revendication 1 ou la revendication 2, dans lequel l'élément de blocage (24) comporte un corps plan dont une surface définit la face de blocage, ce corps ayant un trou traversant qui délimite une ouverture dans la face de blocage et dans lequel l'organe de maintien coulisse entre les première et deuxième positions.

4. Dispositif selon l'une quelconque des revendications 1 à 3, dans lequel l'organe de maintien est une tige dont une extrémité est munie d'une surface plane ayant une forme correspondant à celle de l'ouverture dans la face de blocage.

5. Dispositif selon l'une quelconque des revendications 1 à 4, dans lequel l'organe de protection comporte, sur une surface extérieure, un méplat formant une surface d'appui plane sur laquelle s'appuie l'organe de maintien dans la première position.

6. Dispositif selon l'une quelconque des revendications 1 à 5, dans lequel la face de support et la face de blocage sont parallèles l'une par rapport à l'autre.

7. Installation pour la croissance en solution d'un monocristal, comprenant une cuve destinée à contenir une solution de cristallisation, un dispositif de croissance selon l'une quelconque des revendications 1 à 6, disposé dans la cuve, et des moyens de mise en rotation du dispositif dans la cuve.

8. Procédé de fabrication d'un monocristal par croissance en solution à partir d'un germe cristallin mis en œuvre à l'aide d'une installation selon la revendication 7, le procédé comprenant :
- la fixation du germe cristallin sur la face de support de l'élément de support, le germe cristallin étant orienté suivant l'orientation du monocristal désiré ;
- la mise en place de l'organe de protection autour du germe et son maintien sur la face de support de l'élément de support par pression sur l'organe de protection par l'intermédiaire de l'organe de maintien, qui est placé dans sa première position ;
- la mise en contact de l'organe de protection avec la solution de cristallisation par immersion du dispositif dans la solution de cristallisation ;
- le traitement de la solution de cristallisation pour obtenir une solution sous-saturée ;
- la mise en contact du germe avec la solution de cristallisation sous-saturée par déplacement de l'organe de maintien de sa première position vers sa deuxième position et la mise en rotation du dispositif autour d'un axe essentiellement perpendiculaire à la face de support, le déplacement de l'élément de maintien et la mise en rotation libérant l'organe de protection ;
- la modification de la température de la solution de croissance pour obtenir une solution sursaturée ;
- la croissance du monocristal entre la face de support et la face de blocage à partir de la solution sursaturée, cette croissance étant poursuivie jusqu'à l'obtention d'une croissance latérale désirée ;
- le détachement du monocristal de la face de support et de la face de blocage.

9. Procédé de fabrication selon la revendication 8, dans lequel le monocristal est un monocristal de dihydrogénophosphate de potassium (KDP) ou de dihydrogénophosphate de potassium deutéré (DKDP).

## Patentansprüche

1. Vorrichtung (20) zum Züchten eines flachen Einkristalls aus einem Impfkristall (5) in einer Kristallisationslösung (3), wobei die Züchtungsvorrichtung enthält:
- ein Stützelement (22) mit einer Stützfläche (21) zum Abstützen des Impfkristalls; und
- ein Blockierelement (24) mit einer Blockierfläche (23), wobei die Blockierfläche in einem vordefinierten Abstand von der Stützfläche angeordnet ist, um das Wachstum des Einkristalls in einer Richtung im Wesentlichen senkrecht zur Stützfläche zu blockieren,
wobei die Züchtungsvorrichtung **dadurch gekennzeichnet ist, dass** sie ferner ein Schutzorgan (27) für den Impfkristall enthält, das dazu ausgelegt ist, den Impfkristall vor der Kristallisationslösung (3) während einer Behandlungsphase der Kristallisationslösung zu schützen und bei Drehung des Stützelements (22) eine Wachstumszone freizugeben, die zwischen der Stützfläche (21) und der Blockierfläche (23) angeordnet ist;
wobei das Blockierelement (24) ferner ein mit dem Schutzorgan (27) zusammenwirkendes Halteorgan (25) aufweist, wobei das Halteorgan zwischen einer ersten Position, in der es das Schutzorgan (27) während der Behandlungsphase an der Stützfläche (21) hält, und einer zweiten Position, in der das Halteorgan (25) von dem Schutzorgan (27) gelöst ist und bei der Bildung der Blockierfläche (23) mitwirkt, verstellbar ist.

2. Vorrichtung nach Anspruch 1,
wobei das Schutzorgan (27) ein Hohlkörper ist, der einen offenen Hohlraum definiert, der den Impfkristall während der Behandlungsphase abdecken soll.

3. Vorrichtung nach Anspruch 1 oder Anspruch 2,
wobei das Blockierelement (24) einen ebenen Körper enthält, von dem eine Fläche die Blockierfläche definiert, wobei dieser Körper ein Durchgangsloch aufweist, das eine Öffnung in der Blockierfläche begrenzt und in dem das Halteorgan zwischen der ersten und zweiten Position gleitet.

4. Vorrichtung nach einem der Ansprüche 1 bis 3,
wobei das Halteorgan ein Stab ist, von dem ein Ende mit einer ebenen Oberfläche versehen ist, die in ihrer Form der der Öffnung in der Blockierfläche entspricht.

5. Vorrichtung nach einem der Ansprüche 1 bis 4,
wobei das Halteorgan an einer Außenfläche eine Abflachung aufweist, die eine ebene Auflagefläche bildet, auf der das Halteorgan in der ersten Position aufliegt.

6. Vorrichtung nach einem der Ansprüche 1 bis 5,
wobei die Stützfläche und die Blockierfläche parallel zueinander verlaufen.

7. Anlage zum Züchten eines Einkristalls in Lösung, umfassend einen Behälter zum Aufnehmen einer Kristallisationslösung, eine in dem Behälter angeordnete Züchtungsvorrichtung nach einem der Ansprüche 1 bis 6 und Mittel zum Drehen der Vorrichtung in dem Behälter.

8. Verfahren zur Herstellung eines Einkristalls durch Züchtung in Lösung aus einem Impfkristall, das unter Verwendung einer Anlage nach Anspruch 7 durchgeführt wird, wobei das Verfahren umfasst:
- Befestigen des Impfkristalls an der Stützfläche des Stützelements, wobei der Impfkristall in der Ausrichtung des gewünschten Einkristalls ausgerichtet wird;
- Anordnen des Schutzorgans um den Impfkristall herum und Halten desselben an der Stützfläche des Stützelements durch Drücken auf das Schutzorgan mittels des Halteorgans, das sich in seiner ersten Position befindet;
- Inkontaktbringen des Schutzorgans mit der Kristallisationslösung durch Eintauchen der Vorrichtung in die Kristallisationslösung;
- Behandeln der Kristallisationslösung, um eine ungesättigte Lösung zu erhalten;
- Inkontaktbringen des Impfkristalls mit der untersättigten Kristallisationslösung durch Verlagern des Halteorgans von seiner ersten Position in seine zweite Position und Drehen der Vorrichtung um eine im Wesentlichen senkrecht zur Stützfläche verlaufenden Achse, wobei durch die Verlagerung des Halteorgans und die Drehung das Schutzorgan freigegeben wird;
- Ändern der Temperatur der Züchtungslösung, um eine übersättigte Lösung zu erhalten;
- Züchten des Einkristalls zwischen der Stützfläche und der Blockierfläche ausgehend von der übersättigten Lösung, wobei dieses Züchten solange fortgesetzt wird, bis ein gewünschtes laterales Wachstum erreicht ist;
- Ablösen des Einkristalls von der Stützfläche und der Blockierfläche.

9. Herstellungsverfahren nach Anspruch 8,
wobei der Einkristall ein Einkristall aus Kaliumdihydrogenphosphat (KDP) oder deuteriertem Kaliumdihydrogenphosphat (DKDP) ist.

## Claims

1. A growth device (20) for growing a planar single crystal from a seed crystal (5) in a crystallisation solution (3), said growth device comprising:
- a support element (22) having a support face (21) for supporting the seed crystal; and
- a blocking element (24) comprising a blocking face (23), the blocking face being disposed at a predefined distance from the support face so as to block growth of the single crystal in a substantially perpendicular direction to the support face;
the growth device being **characterized in that** it further comprises a protective member (27) for protecting the seed crystal, configured to protect said seed from the crystallisation solution (3) during a treatment phase of the crystallisation solution and to release a growth zone disposed between the support face (21) and the blocking face (23) upon rotating the support element (22);
the blocking element (24) further including a holding member (25) cooperating with the protective member (27), said holding member being movable between a first position in which it holds the protective member (27) against the support face (21) during the treatment phase and a second position in which the holding member (25) is separated from the protective member (27) and aids in forming the blocking face (23).

2. The device according to claim 1, wherein the protective member (27) is a hollow body defining an open cavity for covering the seed during the treatment phase.

3. The device according to claim 1 or claim 2, wherein the blocking element (24) includes a planar body a surface of which defines the blocking face, this body having a through hole which delimits an opening in the blocking face and wherein the holding member slides between the first and second positions.

4. The device according to any of claims 1 to 3, wherein the holding member is a rod an end of which is provided with a planar surface having a shape corresponding to that of the opening in the blocking face.

5. The device according to any of claims 1 to 4, wherein the protective member includes, on an external surface thereof, a flat forming a planar bearing surface against which the holding member bears in the first position.

6. The device according to any of claims 1 to 5, wherein the support face and the blocking face are parallel to each other.

7. A facility for growing in solution a single crystal, comprising a vessel for containing a crystallisation solution, a growth device according to any of claims 1 to 6, disposed in the vessel, and means for rotating the device in the vessel.

8. A process for manufacturing a single crystal by growth in solution from a seed crystal implemented using a facility according to claim 7, the process comprising:
- fixing the seed crystal to the support face of the support element, the seed crystal being oriented according to the orientation of the desired single crystal;
- placing the protective member around the seed and holding it on the support face of the support element by pressing on the protective member through the holding member, which is placed in its first position;
- contacting the protective member with the crystallisation solution by dipping the device into the crystallisation solution;
- treating the crystallisation solution to obtain an under-saturated solution;
- contacting the seed with the under-saturated crystallisation solution by moving the holding member from its first position to its second position and rotating the device about an axis essentially perpendicular to the support face, moving of the holding element and rotating, which releases the protective member;
- modifying the temperature of the growth solution to obtain an over-saturated solution;
- growing the single crystal between the support face and the blocking face from the over-saturated solution, this growth being continued until a desired lateral growth is obtained;
- detaching the single crystal from the support face and the blocking face.

9. The manufacturing process according to claim 8, wherein the single crystal is a single crystal of potassium dihydrogen phosphate (KDP) or deuterated potassium dihydrogen phosphate (DKDP).
